# EUROPEAN PATENT SPECIFICATION

(11) **EP 2 287 357 B1**
(45) Date of publication and mention of the grant of the patent: **13.04.2016**
(21) Application number: 10173029.9
(22) Date of filing: 17.08.2010
(51) Int. Cl.: C23C 18/16, C23C 18/20, C23C 18/30, C08J 7/02, C23C 18/04, C23C 18/24, C23C 18/28, C23C 18/40

(54) **Preparing substrates containing polymers for metallization**
Herstellung von Substraten mit Polymeren zur Metallisierung
Préparation de substrats contenant des polymères pour la métallisation

(30) Priority: 18.08.2009 US 274505 P
(43) Date of publication of application: 23.02.2011
(73) Proprietor: Rohm and Haas Electronic Materials, LLC, Marlborough, Massachusetts 01752 (US)
(72) Inventor: Li, Crystal P.L, Tin Shui Wai, N.T. (CN); Yee, Dennis K. W., Tuen Mun, N.T (CN); Tang, Michael CY, Tin Shui Wai, N.T. (CN)
(74) Representative: Hoggins, Mark Andrew

(56) References cited:
- EP-A1- 1 236 760
- EP-A1- 1 876 262
- WO-A1-89/10431
- US-A1- 2009 004 382

## Description

The present invention is directed to a method of preparing substrates containing polymers for metallization. More specifically, the present invention is directed to a method of preparing substrates containing polymers for metallization using solvent swells which are stable, homogeneous and low foaming.

Substrates composed of polymers laminated with metal films may be used in the manufacture of printed circuit boards. Typically, the polymers are mixed with inert filler material to form a composite. Two or more of such laminated substrates can be joined together to form multi-layer printed circuit boards. Electrical communication between each laminate of the multi-layer printed circuit board is achieved by electrical connectors which pass through a plurality of metallized through-holes, sometimes referred to as vias, in each board. Through-hole forming operations in such laminates results in smearing of the polymers over the inner-layer copper and the interior wall or barrel of the through-holes. The polymers or resin smear are primarily attributable to the generation or utilization of temperatures exceeding those at which the polymer decomposes during the through-hole forming process. In such instances, resin smear must be removed, often referred to as desmear, from the through-hole walls and from the inner-layer copper if proper metallization of the walls is to be achieved. Besides smear removal, the topography of the through-holes must be altered, i.e., micro-roughened or textured, to achieve better adhesion to deposited metal. Electrical and mechanical integrity required for operation of the boards can only be achieved by insuring that the through-holes are properly prepared to receive metal deposits.

Numerous methods are known for altering the topography and removing resin smear. For example, plasma is widely used to remove polymer components by vaporization. Another approach involves channeling a dry or wet stream of abrasive particles through the through-holes. A similar method uses hydraulic pressure to force thick slurries of abrasive material through the holes. Such mechanical methods are slow and difficult to control and substantial removal of resin smear in the through-holes in a given circuit board is difficult to achieve.

Chemical methods are typically used to alter the topography and remove polymers or resin smear from through-holes. The most common chemical method is treating the through-holes with an oxidizer solution containing permanganate, such as potassium or sodium permanganate. Permanganate treatment may involve three different treatment solutions used sequentially. They are (1) a solvent swell solution, (2) a permanganate resin removal or desmear solution, and (3) a neutralization solution. A substrate containing a plurality of through-holes used in the manufacture of a printed circuit board is dipped or otherwise exposed to each solution with water rinse baths employed between each of these three treatment solutions.

Documents EP 1876262, EP 12236760, WO 89/10431 and US 2009/0004382 describe an electroless metal plating method, wherein as a pretreatment for the metal plating a polymer substrate is first treated with a solvent swell and then an oxidizing solution is applied.

U.S. 5,132,038 discloses a chemical method of removing resin smear from through-holes in preparation for metallization in the manufacture of printed circuit boards. The solvent swell used in the process includes water-immiscible organic liquids, such as ethylene and propylene glycol phenyl ethers, an alkali metal compound, such as sodium hydroxide, and anionic surfactants, such as disulfonated alkyl diphenyl oxides. Other surfactants include glucosides, alkyl naphthalene sodium sulfonates, tetrasodium N-alkylsulfosuccinates, organic phosphate esters, benzene sulfonic acid sodium salt, sodium N-hexyl diphenyloxide disulfonate and similar types of surfactants. The solvent swell softens or swells polymer material in the through-holes to enhance the effectiveness of the subsequent permanganate treatment. The effectiveness of the permanganate treatment refers to its topography altering or micro-roughening capability with respect to the polymers and also may refer to removing or desmearing the polymers on the through-hole walls or etch-back capability. Neutralization follows the permanganate treatment which in turn is followed by other conventional metallization preparation steps.

A disadvantage of many of the solvent swell formulations currently available, including the formulation disclosed in U.S. 5,132,038, is that they are high foaming. High foaming formulations are undesirable because they result in depletion of critical formulation components during use and in operational difficulties during mass production. Depletion of such critical components results in compromised performance of the solvent swell and ultimately in defective products. In other words the solvent swell fails to properly soften or swell the polymers in the through-holes such that micro-roughening and desmear are insufficient for metallization of the through-holes. In addition foam generated during working bath makeup, during rinsing, in which air agitation is often applied, or during spraying in horizontal operation, may lead to contamination of adjacent chemical baths. This results in adhesion failure of the metal deposited in the through-holes or failure of the metal to deposit at all and ultimately in printed circuit board failure. Such defective products increase manufacturing costs as well as increasing the costs to consumers of printed circuit board products.

Although the components of the solvent swell can be replaced, repeated and continuous replacement of the components due to foaming results in additional expense as well as an inefficient manufacturing process. Determining the amount of depleted components in the solvent swell and replacing them accurately to achieve the desired performance present challenges. It is difficult to accurately determine the amount of a given component lost by foaming and at the same time accurately replace the component.

Foaming may be caused by one or more components in the solvent swell formulation. It may be caused by the component which micro-roughens or desmears. Foaming may also be caused by one or more surfactants which are typically included in solvent swells or other components included in the formulation. Although there are low foaming compounds, in addition to being low foaming, compounds added to the solvent swell must be compatible with each other and provide a stable, homogeneous and reliable formulation. In other words, a known low foaming surfactant may not be suitable for a solvent swell formulation if it results in an unstable, non-homogeneous solvent swell or compromises the performance of the other components, in particular the micro-roughening and desmearing properties. The solvent swell must prepare the walls of the through-holes for metallization of high integrity.

Another disadvantage of many solvent swells is that they are limited in the types of polymers which they can soften. In the past the printed circuit board industry typically used polymers which had relatively low T_{g} values of less than 150° C. Many solvent swells currently on the market are suitable for swelling and softening such polymers; however, more recently the printed circuit board industry has discovered that many polymer materials which have T_{g} values of 150° C and higher are more desirable in the manufacture of printed circuit boards. Unfortunately, such high T_{g} polymers are resistant to many of the solvent swells currently available. Therefore, in addition to the other properties described above, the industry desires and needs a solvent swell which can soften polymers within a wide T_{g} range, including high T_{g} polymers.

Accordingly, there is a need for a method of preparing through-holes or vias for metallization which utilizes a solvent swell which is low foaming, stable, homogeneous, does not compromise micro-roughening and polymer removal performance and may be used to swell and soften polymers within a wide range of T_{g} values, including high T_{g} polymers.

The presently claimed subject matters are as set out in the accompanying claims.

Methods include: a) providing a substrate containing polymers and a plurality of vias; b) applying a solvent swell composition including one or more amphoteric surfactants one or more organic solvents and one or more dispersing agents onto the substrate containing the polymers and the plurality of vias to swell the polymers in the plurality of vias; and c) subsequently applying an oxidizer to the swollen polymers to topographically alter or remove the polymers in the vias.

The methods include solvent swells which are stable, homogeneous, low foaming and swell and soften polymers of substrates in preparation for topographically altering or removing the polymers with an oxidizer prior to metallization of the vias of the substrates. The low foaming properties of the solvent swells reduce the probability of having to replenish depleted critical components during use as well as reducing the probability of contamination of equipment, adjacent chemical baths and work areas. This, in turn, prevents board failure due to malfunction of contaminated chemical baths and also prevents the necessity of a temporary shut-down of manufacturing. Accordingly, the methods provide for more efficient and cost effective processes than many conventional processes while providing reliable methods for the metallization of vias. compositions used in the methods do not compromise the topographically altering and polymer removing performance of the oxidizer.

The methods may be used to swell, topographically alter and remove a wide variety of polymers, including polymers having low to high T_{g} values. The method may be used in both vertical and horizontal processes of manufacturing printed circuit boards.

As used throughout this specification, the abbreviations given shall have the following meanings, unless the context clearly indicates otherwise: g = gram; mg = milligram; mm = millimeter; cm = centimeter; L = liter; mL = milliliters; ° C = degrees Celsius; g/L = grams per liter; wt% = percent by weight; SEM = scanning electron micrograph; and T_{g} = glass transition temperature.

The terms "printed circuit board" and "printed wiring board" are used interchangeably throughout this specification. The term "via" refers to an orifice in a printed wiring board which penetrates entirely through the board known as a through-hole or one which originates at a surface of the board but only extends through a limited part of the board known as a blind via. The term "hydrotrope" means a compound which solubilizes a hydrophobic compound in aqueous solutions. The expression "polymer removal" is synonymous with desmear. All amounts are percent by weight, unless otherwise noted. All numerical ranges are inclusive and combinable in any order except where it is clear that such numerical ranges are constrained to add up to 100%.

The compositions including one or more amphoteric surfactants, one or more organic solvent and one or more dispersing agents may be used to swell and soften a variety of polymers and polymer mixtures prior to topographical alteration, i.e., micro-roughening, and polymer removal. Polymers include, but are not limited to, epoxies such as difunctional and multifunctional epoxies, polyimides, cyanate esters, bismaleimide triazines ("BT"), polymer and resin coated copper ("RCC") type materials, epoxy/polyphenylene oxides, and mixtures thereof. The compositions may also be useful in swelling polymers, such as, but not limited to, acrylonitrilebutadienestyrene, polycarbonates ("PC"), polyphenylene oxides ("PPO"), polyphenylene ethers ("PPE"), polyphenylene sulfides ("PPS"), polysulfones ("PS"), polyamides, polyesters such as polyethyleneterephthalate ("PET") and polybutyleneterephthalate ("PBT"), polyetheretherketones ("PEEK"), liquid crystal polymers, polyurethanes, polyetherimides, and mixtures thereof.

The polymers may be reinforced with various inorganic materials such as mica and glass. Typically, the polymers are either epoxy-based, such as glass filled epoxy resins of difunctional or tetrafunctional epoxy type or cresol or phenol novolaks, bis-maleimide triazine, or polyimide based resins.

The solvent swell compositions may be used to swell low to high T_{g} polymers and polymer mixtures. In general, "low T_{g} polymers" have glass transition temperatures of less than 150° C, and "high T_{g} polymers" have glass transition temperatures of 150° C and higher. High T_{g} polymers are typically used in sequential build up ("SBU") applications in the manufacture of printed circuit boards.

Typically, the polymer materials are a base component of a substrate where at least one side of the polymer is coated with a metal film. Such substrates are typically used in the manufacture of printed wiring boards where the polymer materials form inner layers of the boards. The boards may be single or multi-layer boards.

In general, the compositions which include the one or more amphoteric surfactants, one or more water organic solvents and one or more dispersing agents are applied to the substrate containing the polymers to soften and swell the polymers. Subsequently, the softened and swollen polymers are topographically altered and some of the polymers may be removed with an oxidizer. The solvent swell composition may be applied to the substrate by any suitable method. For example, the composition may be applied by immersing the substrate into a bath containing the composition, or the composition may be sprayed onto the substrate. The solvent swell compositions may be used wherever polymers require swelling and softening.

Typically, the methods are used in the manufacture of printed circuit boards. In the manufacture of printed circuit boards, vias are punched or drilled in each circuit board substrate. The solvent swell compositions are applied on the substrate such that the solvent swell infiltrates the vias to swell and soften any polymers or smear in the interior of the vias. The solvent swell composition may be used in either vertical or horizontal systems.

In general, the solvent swell compositions are applied to the substrate for 30 seconds to 15 minutes. Typically, the composition is applied to the substrate for one minute to 10 minutes. The substrate is then rinsed with water.

Amphoteric surfactants used in the solvent swell compositions are hydrotropic and low foaming. Amphoteric surfactants contain or have the potential to form both positive and negative functional groups. Low foaming amphoteric surfactants also include those amphoteric surfactants which typically do not produce any noticeable foaming activity. The amphoteric surfactants are also compatible with the other components of the solvent swell such that the solvent swell composition is stable and homogeneous. In addition, the amphoteric surfactants do not compromise the micro-roughening and polymer removal performance, thus providing metal deposits with high integrity adhesion. Such amphoteric surfactants may be included in the solvent swells in amounts of 50 g/L to 500 g/L or such as from 100 g/L to 300 g/L or such as 120 g/L to 200 g/L.

Such amphoteric surfactants are chosen from n-alkylamino propionates and n-alkylamino dipropionates and mixtures thereof. The n-alkylamino propionates and the n-alkylamino dipropionates include, but are not limited to compounds having the following general structures:

R-NH-CH₂-CH₂-COOX

and

R-N(CH₂CH₂COOX)₂

where R is an alkyl or hydroxyalkyl group of 8 to 22 carbon atoms and X is hydrogen, ammonium or an alkali metal, such as sodium or potassium. Typically, one or more n-alkylamino propionates are included in the solvent swell compositions.

Organic solvents include organic solvents which swell and soften the polymer material of the substrate. In addition, such organic solvents provide a stable homogeneous solvent swell composition. The organic solvents may be water-immiscible or water-miscible. In general, water-immiscible organic solvents are those organic liquids which do not form homogeneous mixtures with water, and water-miscible organic solvents are organic liquids which form homogenous mixtures with water. Organic solvents are included in the compositions in amounts of 50 g/L to 500 g/L, or such as from 100 g/L to 300 g/L, or such as 120 g/L to 200 g/L. Typically, water-immiscible organic solvents are included in the solvent swell compositions.

Water immiscible organic solvents include, but are not limited to, glycol phenyl ethers, such as ethylene glycol phenyl ether and propylene glycol phenyl ether, lactones, such as valerolactone, and malonates, such as dimethyl malonate and diethyl malonate.

Water miscible organic solvents include, but are not limited to, glycol ethers, such as diethylene glycol monomethyl ether, diethylene glycol monopropyl ether, diethylene glycol monobutyl ether, ethylene glycol monomethyl ether, ethylene glycol monopropyl ether, ethylene glycol monobutyl ether, dipropylene glycol monomethyl ether, dipropylene glycol monopropyl ether and dipropylene glycol monobutyl ether, and lactones, such as caprolactone and butyrolactone, and pyrrolidones, such as 1-(2-hydroxyethyl)-2-pyrrolidone, N-methyl-pyrrolidone and 2-pyrrolidone.

Dispersing agents included in the solvent swells have hydrotropic properties, have cloud points of 100° C and higher, or have no cloud point. They are soluble in water or organic solvent based compositions. Such dispersing agents must be compatible with the other components of the solvent swell and provide a stable and homogeneous composition and not compromise the topographical and desmearing ability of the oxidizer. The dispersing agents are anionic or non-ionic, and typically the dispersing agents are anionic. Examples of anionic dispersing agents are alkyl diphenyl oxides, tetrasodium N-alkylsulfosuccinate, organic phosphate esters, and polyether sulfates. Examples of non-ionic dispersing agents are secondary alcohol ethoxylates and surfactants derived from vegetable oil, such as seed oil. Such dispersing agents are vegetable oil, such as seed oil. Such dispersing agents are included in the compositions in amounts of 25 g/L to 200 g/L or such as from 50 g/L to 150 g/L.

Optionally, the solvent swell compositions may also include one or more alkali metal compounds. Such alkali metal compounds include alkali metal hydroxides, carbonates, silicates and phosphates. Typically, the alkali metal compounds are one or more alkali metal hydroxides, such as sodium and potassium hydroxides. Alkali metal compounds are included in the compositions in amounts of 0.5 gm/L to 50 g/L, or such as from 5 g/L to 40 g/L.

Typically, the solvent swell compositions are aqueous based and consist essentially of one or more amphoteric surfactants, one or more organic solvents and one or more dispersing agents. More typically, the solvent swell composition consists essentially of one or more amphoteric surfactants, one or more water immiscible organic solvents and one or more anionic dispersing agents. The components of the solvent swell may be combined in any order to form stable and homogeneous aqueous solutions. The components in the solvent swell do not precipitate out of solution and the component parts do not separate into various layers at room temperature or within operating temperature ranges.

The temperature used during solvent swell application depends upon the particular components used in the solvent swell and the concentrations of such components. Typically, the solvent swell compositions may be used from room temperature to 90° C, more typically from 60° C to 90° C.

After rinsing the substrate with water, an oxidizer, such as an alkaline solution containing permanganate ions, such as sodium or potassium permanganate, is applied to the through-holes. In addition to the permanganate, alkali metal hydroxides or alkaline earth hydroxides may be included in the permanganate solutions as a hydroxide ion source. Typically, the hydroxide ion source is an alkali metal hydroxide. Such alkali metal hydroxides include, but are not limited to sodium hydroxide and potassium hydroxide. Mixtures of hydroxide ion sources may also be used. Typically, the hydroxide ion sources are used in the permanganate solutions in an amount such that the pH of the permanganate solution is from 12 to 14. The concentration of permanganate typically is from 20 g/L to 150 g/L. By virtue of the solvent swell treatment, the oxidizer affects a micro-roughening of the polymers in the vias and to remove some polymer material, thus providing a receptive environment for the adsorption of catalytic species for electroless metal deposition and adherence of metal on the via walls. Conventional conditions well known in the art may be used to micro-roughen or remove polymers from the vias. Alternatively, the method may be used as an etch-back. Such etch-back conditions are conventional and well known in the art.

The method described above may constitute the entire preparation of via surfaces or may form a part of a multi-treatment via preparation process. The solvent swell composition with the permanganate process may be relied upon to micro-roughen via surfaces. Subsequent rinsing with water may sufficiently neutralize residual permanganate and manganese species. Metallization of the vias may then follow.

Although water rinsing may sometimes remove or neutralize a sufficient amount of permanganate and manganese species remaining on the walls of the vias, typically a neutralization step is included in the metallization process. There are a number of conventional neutralization formulations known in the art which may be readily obtained commercially or from the literature. Typically, neutralizing or reducing agents, such as hydroxylamine or salts thereof are used in conventional amounts and under conventional conditions. Also, a dilute solution of sulfuric acid and hydrogen peroxide may be used to neutralize or remove any residues. After neutralization, the substrate is then rinsed with water.

Additional steps which are included in the preparation of metallization include, but are not limited to, conditioning the vias following neutralization. Conditioning makes the vias positively charged to allow negatively charged catalysts to deposit catalytic metals on via walls which in turn permit the deposit of electroless metal on the walls. Numerous conventional conditioners are known and commercially available as well as disclosed in the literature. Such conditioners are applied in conventional amounts and under conventional conditions. Examples of commercially available conditioners are CIRCUPOSIT™ Conditioners 3320 and 3325 solutions (available from Rohm and Haas Electronic Materials, LLC, Marlborough, MA). Conventional parameters for applying the conditioners may be used. After conditioning the vias, the substrate is rinsed with water.

After to conditioning, the vias are typically micro-etched. Micro-etching is done using conventional micro-etch formulations and processes. For example, the vias may be micro-etched with an aqueous solution containing 50 g/L to 200 g/L of sodium per sulfate and from 1 % to 10% by weight of sulfuric acid. The substrate may be immersed in the micro-etch solution or the solution may be sprayed onto the substrate. Typically, the substrate is then rinsed with water.

Metallization of the vias may be done by conventional electroless metal plating. The vias are made electrically conductive by applying an activator to the vias. Such activators may be colloidal catalysts of noble or non-noble metals. Noble metals used as activators include, but are not limited to, gold, silver, platinum and palladium. Typically, palladium is used. Typically, the palladium is used as a tin-palladium colloid, such as the commercially available activator CIRCUPOSIT™ 3344 Activator (available from Rohm and Haas Electronic Materials, LLC). Another commercially available activator is CATAPOSIT™ 44 activator (available from Rohm and Haas Electronic Materials, LLC). Examples of non-noble metal activators are copper and nickel. When a non-noble metal is used, it is typically copper. Copper is typically used in the colloidal catalyst as a copper oxide.

Optionally, accelerators may be used to increase or optimize the catalytic activity of the activator. Conventional accelerators may be used. Many are commercially available or disclosed in the literature. An example of an accelerator which may be used is a fluoroborate based accelerator. Accelerators are applied as a post-dip after the application of the activator. Conventional parameters for applying accelerators may be used. An example of a commercially available accelerator is Accelerator 19 (available from Rohm and Haas Electronic Materials, LLC). The substrate is rinsed with water between application of the accelerator and the activator.

Via walls may be plated using conventional electroless metal plating baths and processes. Typically, the vias are electrolessly plated with copper. The types and amounts of components in such baths vary extensively. There are a variety of electroless copper plating baths which are commercially available or disclosed in the literature. Examples of commercially available electroless copper metal plating baths are CIRCUPOSIT™ 3350-1 and 880 Electroless Copper plating baths (available from Rohm and Haas Electronic Materials, LLC).

In general, aqueous copper electroless plating baths which may be used include, but are not limited to, one or more sources of copper ions, one or more reducing agents, one or more complexing agents and one or more buffering agents. Typically, one or more surfactants are included in the bath.

Typically, the source of copper ions is provided by copper sulfate pentahydrate. Other copper salts may be used provided that they are water soluble. Many of such copper salts are commercially available or available in the literature. In general, such copper salts are included in the baths in amounts of 8 g/L to 10 g/L.

Reducing agents which may be included in the electroless copper bath include, but are not limited to, formaldehyde, formaldehyde precursors, formaldehyde homopolymers such as paraformaldehyde, trioxane and glyoxyl, borohydrides such as alkali metal borohydride and substituted borohydrides and hypophosphite reducing agents. Such reducing agents may be included in amounts of 1 mL/L to 6 mL/L.

Complexing agents include, but are not limited to, Rochelle salts, ethylene diamine tetraacetic acid (EDTA), salts of EDTA, nitrile tetraacetic acid and its alkali salts, gluconic acid, gluconates, triethanolamine, glucono (gamma)-lactone, modified ethylene diamine acetates, such as N-hydroxyl ethyl ethylene diamine triacetate. Such complexing agents may be included in the baths in amounts of 30 g/L to 50 g/L.

Buffering agents include, but are not limited to, sodium hydroxide or potassium hydroxide. Typically they are used in amounts to provide a pH of 10 to 13.

Various surfactants may be included in the electroless copper plating baths, such as non-ionic, cationic or anionic surfactants. The amounts typically range from 1 g/L to 10 g/L. Such surfactants are well known in the art and many may be obtained commercially or are disclosed in the literature.

After electroless plating of the vias, select sections of the substrate are typically further metallized using conventional electroplating methods. Typically, the electroplated metal is copper. An example of a suitable commercially available copper metal electroplating bath is COPPER GLEAM™ 125T-AB Electrolytic Copper plating bath (available from Rohm and Haas Electronic Materials, LLC).

In general, a basic copper electroplating bath may include copper sulfate pentahydrate, sulfuric acid, and one or more water-soluble chlorine compounds. The concentration of the copper sulfate pentahydrate may range from 20 g/L to 250 g/L. Sulfuric acid may be included in the bath in amounts of 30 g/L to 400 g/L. Water-soluble chlorine compounds may be included in amounts of 10 mg/L to 200 mg/L. Examples of such water-soluble chlorine compounds are hydrochloric acid, sodium chloride, potassium chloride and ammonium chloride. In addition, the copper electroplating baths may include other additives typically used in such baths, including, but not limited to surfactants, buffering agents, brighteners, levelers, suppressors and grain refiners. Such additives may be included in conventional amounts and are well known in the art and many are commercially available or disclosed in the literature. Copper electroplating is done at conventional current densities, pH and temperatures.

The low foaming properties of the solvent swell reduce the probability of having to replenish depleted components during use as well as reducing the probability of contamination of adjacent chemical baths, equipment and work areas. This in-turn prevents printed wiring board failure due to malfunction of contaminated chemical baths and also prevents the necessity of a temporary shut-down of manufacturing. Accordingly, the method provides for a more efficient and cost effective process than many conventional processes while providing a reliable preparation method for the metallization of vias. The solvent swell composition used in the method is also stable, homogeneous and does not compromise the topographically altering or desmear performance of the oxidizer. Polymers treated with the solvent swell composition followed by an oxidizer provide good micro-roughening of the polymer and good adhesion of metals plated on the micro-roughened polymer. The probability of de-lamination of metal deposits is reduced and the reliability of the final electronic product is improved.

The method may be used to swell and soften and topographically alter a wide variety of polymers, including polymers having low Tg values, i.e. less than 150° C, to high T_{g} values, i.e., 150° C and greater. Solvent swells which may be used to swell and soften high T_{g} polymers are highly desirable in the industry because they are typically resistant to many conventional solvent swells and such high T_{g} polymers are becoming more and more common in the printed circuit board industry. The method may be used in both vertical and horizontal processes of manufacturing printed circuit boards where high foaming typically causes manufacturing shut-down and process inefficiency due to depletion of solvent swell components, cross-contamination of chemical baths and the necessity of workers having to clean any spillage before resuming the process.

While the methods have been described with respect to the preparation of vias for metallization in the manufacture of printed circuit boards, those of ordinary skill in the art can appreciate that the methods and solvent swells may be applied to a wide variety of polymer containing substrates in a wide variety of applications where swelling and softening of polymers is desired.

The following examples are intended to illustrate various aspects of the methods and solvent swells, but are not intended to limit their scope.

### Examples 1 (Comparative)

Ross-Miles Foam Height Tests (ASTM D1173-53) were taken on ten aqueous solvent swell samples. Samples 1-5 (Table 1) were not diluted. Samples 6-10 (Table 2) were diluted with water to form a 0.5% solution in order to mimic rinsing. 200 mL samples of each solvent swell test solution at concentrations by weight percent were dropped through a cylinder and impacted with 50 mL of the same solution. Due to the impacting force, foam was generated and its height in centimeters was measured initially and after 5 minutes. The test was done at room temperature. The test without dilution of the solvent swell was done twice.

**Table 1**

| **Sample** | Ethylene glycol phenyl ether | Disulfonated alkyl diphenyl oxide | Alkylamino propionate | Trial 10 minutes (initial) | Trial 15 minutes (final) | Trial 20 minutes (initial) | Trial 25 minutes (final) |
|---|---|---|---|---|---|---|---|
| 1 | 150 g/L | 220 g/L | 0 g/L | 12.5 cm | 2 cm | 12 cm | 1.5 cm |
| 2 | 150 g/L | 150 g/L | 70g/L | 12.5 cm | 1.5 cm | 11.5 cm | 1 cm |
| 3 | 150 g/L | 110 g/L | 110 g/L | 11.5 cm | 1 cm | 11.5 cm | 1 cm |
| 4 | 150 g/L | 90 g/L | 130 g/L | 10.5 cm | 0 cm | 11 cm | 1 cm |
| 5 | 150 g/L | 70 g/L | 150 g/L | 11 cm | 0.5 cm | 11 cm | 0.5 cm |

The test results showed that the samples which included the alkylamino propionate had the lowest foam height after 5 minutes. The best results were achieved with samples 4 and 5 in the first trial where foam height was 0 and 0.5 cm, respectively, and sample 5 in the second trial where foam height was 0.5 cm.

**Table 2**

| **Sample** | Ethylene glycol phenyl ether (prior to dilution) | Disulfonated alkyl diphenyl oxide (prior to dilution) | Alkylamino propionate (prior to dilution) | 0 minutes (initial) | 5 minutes (final) |
|---|---|---|---|---|---|
| 6 | 150 g/L | 220 g/L | 0 g/L | 12 cm | 11.5 cm |
| 7 | 150 g/L | 150 g/L | 70 g/L | 10.5 cm | 10.5 cm |
| 8 | 150 g/L | 110 g/L | 110 g/L | 9 cm | 8.5 cm |
| 9 | 15 g/L | 90 g/L | 130 g/L | 4 cm | 4 cm |
| 10 | 15% | 70 g/L | 150 g/L | 4 cm | 2 cm |

The solvent swell formulations in Table 2 were diluted with water to 0.5% volume by volume of their initial concentrations prior to doing the foam test to mimic rinsing. The results showed that the test samples which included the alkylamino propionate had the lowest foam height after 5 minutes. The best results were achieved with samples 9 and 10 where foam height was 4 cm initially and 4 cm and 2 cm, respectively, after 5 minutes.

### Examples 2 (Comparative)

A strong air flow rate test was done to mimic the spray effect and measure the foam height for four solvent swell formulations. Table 3 below discloses the formulations tested.

**Table 3**

| **Sample** | Ethylene glycol phenyl ether | Disulfonated alkyl diphenyl oxide | Alkylamino propionate | Foam Height at 1 minute | Foam Height at 5 minutes | Foam Height at 10 minutes |
|---|---|---|---|---|---|---|
| 11 | 150 g/L | 220 g/L | 0 g/L | 5 cm | 11 cm | 12 cm |
| 12 | 150 g/L | 88 g/L | 132 g/L | 3 cm | 4 cm | 4 cm |

500 mL of the solvent swell test solution was added to a 2000 mL beaker. An air flow rate of 1 L/minute was contiuously pumped through the 500 mL test solution in order to estimate the effect during application of the solvent swell when used in a horizontal process for manufacture of printed circuit boards. The air flow rate for the solvent swells in samples 11 and 12 was one liter per minute. The results showed that the solvent swell which included the alkylamino propionate had reduced foam generation at all three time periods where the foam was measured.

The test was repeated except that the solvent swell test solutions were diluted to 0.5% volume by volume in order to mimic rinsing. The air flow rate was 2.5 L/minute. Table 4 shows the foam height of each sample at the measuring times.

**Table 4**

| **Sample** | Ethylene glycol phenyl ether (prior to dilution) | Disulfonated alkyl phenyl oxide (prior to dilution) | Alkylamino propionate (prior to dilution) | Foam Height at 1 minute | Foam Height at 5 minutes | Foam Height at 10 minutes |
|---|---|---|---|---|---|---|
| 13 | 150 g/L | 220 g/L | 0 g/L | 15 cm | Exceeded test limit | Exceeded test limit |
| 14 | 150 g/L | 88 g/L | 132 g/L | 1 cm | 1 cm | 1 cm |

The results showed that the solvent swell 14 which included the alkylamino propionate had reduced foam generation at all three time periods where the foam was measured. No foam height values were obtained for sample 13, which excluded alkylamino propionate, because the foam exceeded the height of the beaker and overflowed after one minute. The foaming results showed that the addition of alkylamino propionate significantly reduced foaming regardless of whether or not it was in concentrated form or as a dilute solution.

### Example 3 (Comparative)

Four S1000-2 high T_{g} (170° C) epoxy boards with a plurality of through-holes were provided by supplier Sheng Yi Company (Dongguan city, Guangdong China). One board was cross sectioned and the surfaces of the exposed through-holes were examined using SEM. The surfaces of the walls of the through-holes contained smear caused by the through-hole drilling process.

The second board was immersed in an aqueous oxidizer solution containing potassium permanganate at a concentration of 50 g/L and a pH of 12. The temperature of the solution was 80° C. The board was immersed in the aqueous oxidizer solution for 12 minutes. After removing the board from the oxidizer solution, it was rinsed with water. After a neutralizing step with CIRCUPOSIT™ MLB Neutralizer 216-5 the board was then cross sectioned to expose a plurality of through-hole wall surfaces. The walls of the through-holes were examined for resin smear with SEM. The SEM results showed that some smear was removed from the through-hole walls; however, a majority of the through-hole wall surfaces were still coated with resin smear. Further, there was no observable micro-roughening of the wall surfaces.

The third board was immersed in an aqueous solvent swell solution containing 150 g/L of ethylene glycol phenyl ether and 220 g/L of disulfonated alkyl diphenyl oxide. The board was immersed in the solution for 8 minutes at 80° C. The board was removed from the solvent swell and rinsed with water for 4 minutes in which air agitation was provided for better circulation. Significant foam was observed during rinsing. It was then immersed in an oxidizer solution for 12 minutes containing potassium permanganate at a concentration of 50 g/L and a pH of 12. The temperature of the solution was 80° C. The board was rinsed with water for 4 minutes after removing it from the oxidizer solution. After a neutralizing step the board was then cross sectioned to expose a plurality of through-hole wall surfaces. The walls of the through-holes were examined for resin smear with SEM. The SEM results showed that there was an increase in the amount of resin smear removed from the wall surfaces in contrast to the walls of the second board treated only with the oxidizer solution. Further, the wall surfaces were micro-roughened.

The fourth board was immersed in an aqueous solvent swell solution containing 150 g/L of ethylene glycol phenyl ether, 88 g/L of disulfonated alkyl diphenyl oxide and 132 g/L of n-alkylamino propionate. The board was immersed in the solution for 8 minutes at 80° C. The board was removed from the solvent swell and rinsed with water for 4 minutes in which air agitation was provided for better circulation. Foaming generated during rinsing was negligible and significantly less than the solvent swell used to treat the third board. It was then immersed in an oxidizer solution containing potassium permanganate at a concentration of 50 g/L and a pH of 12 for 12 minutes. The temperature of the solution was 80° C. The board was rinsed with water for 4 minutes after removing it from the oxidizer solution. After a neutralizing step the board was then cross sectioned to expose a plurality of through-hole wall surfaces. The walls of the through-holes were examined for resin smear with SEM. The SEM results showed that there was an increase in the amount of resin smear removed from the wall surfaces in contrast to the walls of the second board. Further, the wall surfaces were micro-roughened.

The addition of the n-alkylamino propionate to the solvent swell did not compromise the swelling performance of the solvent swell which in turn still enabled the oxidizer to remove smear from the through-hole walls and micro-roughen the walls in preparation for metallization. In addition, the n-alkylamino propionate significantly reduced foaming in contrast to the solvent swell which excluded the propionate. Further, the solvent swell with the propionate appeared stable and homogeneous.

### Example 4 (Comparative)

The procedure described in Example 3 was repeated except that four low T_{g} (140° C) epoxy boards from Sheng Yi were provided. One board was cross sectioned after drilling a plurality of through-holes and the walls of the through-holes were examined for smear using SEM. All of the walls which were examined showed significant resin smear.

Each of the remaining three boards was then treated with one of the three solutions described in Example 3 and under the same treatment conditions. The board which was treated with only the aqueous potassium permanganate solution showed no observable smear removal or micro-roughening of the through-hole walls. The appearance of the walls surfaces was substantially the same as in the un-treated board.

The board which was treated with the solvent swell containing the ethylene glycol phenyl ether and the disulfonated alkyl diphenyl oxide followed by oxidizer treatement showed increased smear removal in contrast to the second board as well as a honeycomb texturing of the through-hole walls. However, the solvent swell foamed substantially as in Example 3.

The fourth board which was treated with the solvent swell containing ethylene glycol phenyl ether, disulfonated alkyl diphenyl oxide and n-alkylamino propionate followed by treatment with the potassium permanganate oxidizer also showed increased smear removal in contrast to the board only treated with the oxidizer. In addition, the SEM analysis of the fourth board showed the same honeycomb micro-roughening as the third board. Further, almost no foaming was observed during the solvent swell process.

The addition of the n-alkylamino propionate to the solvent swell did not compromise its performance which in turn still enabled the oxidizer to remove smear from the through-hole walls and micro-roughen the walls in preparation for metallization. In addition, the n-alkylamino propionate significantly reduced foaming in contrast to the solvent swell which excluded the propionate. Further, the solvent swell with the propionate appeared stable and homogeneous.

### Example 5

Seven laminated copper clad boards are provided. A first group of three epoxy laminates have T_{g} values of 170° C (Models: Polyclad 370 HR, obtainable from Isola Laminate Systems Corp. La Crosse Wisconsin, S1000-2 and TUC-752 obtainable from Sheng Yi and Taiwan Union Technology Corp. Chupei City Hsinchu Hsien, Taiwan, respectively). One epoxy laminate (Model: IT-180 obtainable from ITEQ corp. Ping-Cheng Industrial Zone, Taoyuan, Taiwan) has a T_{g} of 180° C. Three epoxy laminates have T_{g} values of 150° C (Models: NPG, obtainable from Nan Ya Plastics Corp. Shu-Lin Villa, Taipei Country, Taiwan, S-1000 and S-1141 obtainable from Sheng Yi). Each board is drilled with a plurality of through-holes using a conventional drill used in the industry for such a purpose. There are from 500 to 1000 through-holes per board and each hole is approximately 1 mm in diameter.

Two stock solutions of aqueous solvent swell compositions are made. The first solvent swell includes 150 g/L of ethylene glycol phenyl ether, 220 g/L of disulfonated alkyl diphenyl oxide. The second solvent swell includes 150 g/L of propylene glycol phenyl ether, 88 g/L of disulfonated alkyl diphenyl oxide and 132 g/L of n-alkylimino dipropionate.

One of each type of board is immersed in the first solvent swell and one of each type of board is immersed in the second solvent swell. Each board is left in its respective solution for 8 minutes. The temperature of the solutions is 80° C. The solvent swell solutions swell and soften the polymer components of the boards. Each board is removed from the solvent swells and rinsed with water for 3 minutes in which air agitation is provided for better circulation. Significant foam is generated during the rinsing process of the first solvent swell whereas minimum foam is observed for the second solvent swell which included the n-alkylamino dipropionate. No replacement components are needed to be added to the second solvent swell to maintain swelling performance due to loss during foaming. The solvent swell compositions appear both stable and homogeneous throughout the process.

Each board is then immersed in an aqueous alkaline oxidizer solution containing 50 g/L potassium permanganate and a pH of 12 to desmear and micro-roughen through-hole walls. The temperature of the oxidizer solution is 80° C. The solution is continuously mixed during the immersion of the boards. The boards remain in the solution for 12 minutes. The boards are then removed and rinsed with water for 4 minutes.

A neutralizer is then applied to each board at a temperature of 40° C. The boards were left in the neutralizer for 5 minutes then removed and rinsed with water for 4 minutes.

Subsequent to neutralization each board is then treated with CIRCUPOSIT™ Conditioner 3320 solution. Conditioning is done for 5 minutes at 60° C. The boards are then rinsed with water for 4 minutes.

After conditioning the through-holes they are micro-etched. Each board is immersed into an aqueous solution containing 100 g/L of sodium persulfate and 2% sulfuric acid. The solution is mixed during micro-etching and the temperature of the micro-etch bath is 30° C. Micro-etching is done for 1 minute. Each board is removed from the micro-etch and rinsed with water for 2 minutes.

Each board is then immersed in CATAPOSIT™ 404 Predip solution for 1 minute at room temperature. The boards are removed and then immersed in CATAPOSIT™ 44 Palladium and Tin catalyst. The boards remain in the catalyst for 5 minutes at 40° C. They are then removed and rinsed with water for 2 minutes.

The through-hole walls of each board are then metallized with electroless copper. Metallization is done by immersing each board in the electroless copper bath CIRCUPOSIT™ 880 Electroless Copper plating solution for 15 minutes at 30° C. The boards are removed from the copper solution and rinsed with water for 3 minutes.

Each board is then cross sectioned to expose the copper plated walls of the through-holes. All of the walls observed using SEM appear to have uniform copper deposition and adhesion of the copper to the walls appears to be of high integrity, i.e., no copper deposit peeling.

## Claims

1. A method comprising:
a) providing a substrate comprising one or more polymers and a plurality of vias;
b) applying a solvent swell composition comprising one or more amphoteric surfactants chosen from n-alkylamino propionates and n-alkylamino dipropionates, one or more organic solvents and one or more dispersing agents chosen from anionic surfactants and non-ionic surfactants onto the substrate comprising the one or more polymers and the plurality of vias to swell the one or more polymers; and
c) subsequently applying an oxidizer to the swollen one or more polymers to topographically alter or desmear the one or more polymers in the plurality of vias.

2. The method of claim 1, further comprising a step of metallizing walls of the plurality of vias.

3. The method of claim 1, wherein the one or more organic solvents are chosen from water-immiscible organic solvents and water-miscible organic solvents.

4. The method of claim 3, wherein the water-immiscible organic solvent is a glycol phenyl ether.

5. The method of claim 3, wherein the water-miscible organic solvent is a glycol ether.

6. The method of claim 1, wherein the substrate is a printed circuit board.

7. The method of claim 1, wherein the one or more amphoteric surfactants are included in amounts of 50 g/L to 500 g/L.

## Patentansprüche

1. Ein Verfahren, das Folgendes beinhaltet:
a) Bereitstellen eines Substrats, das ein oder mehrere Polymere und eine Vielzahl von Durchkontaktierungen beinhaltet;
b) Aufbringen einer Lösungsmittelquellzusammensetzung, beinhaltend ein oder mehrere amphotere Tenside, ausgewählt aus N-Alkylaminopropionaten und N-Alkylaminodipropionaten, ein oder mehrere organische Lösungsmittel und ein oder mehrere Dispergiermittel, ausgewählt aus anionischen Tensiden und nichtionischen Tensiden, auf das Substrat, das das eine oder die mehreren Polymere und die Vielzahl von Durchkontaktierungen beinhaltet, um das eine oder die mehreren Polymere aufquellen zu lassen; und
c) anschließendes Aufbringen eines Oxidationsmittels auf das eine oder die mehreren aufgequollenen Polymere, um das eine oder die mehreren Polymere in der Vielzahl von Durchkontaktierungen topographisch zu verändern oder zu desmearen.

2. Verfahren gemäß Anspruch 1, das ferner einen Schritt des Metallisierens von Wänden der Vielzahl von Durchkontaktierungen beinhaltet.

3. Verfahren gemäß Anspruch 1, wobei das eine oder die mehreren organischen Lösungsmittel aus nicht mit Wasser mischbaren organischen Lösungsmitteln und mit Wasser mischbaren organischen Lösungsmitteln ausgewählt sind.

4. Verfahren gemäß Anspruch 3, wobei das nicht mit Wasser mischbare organische Lösungsmittel ein Glykolphenylether ist.

5. Verfahren gemäß Anspruch 3, wobei das mit Wasser mischbare organische Lösungsmittel ein Glykolether ist.

6. Verfahren gemäß Anspruch 1, wobei das Substrat eine Leiterplatte ist.

7. Verfahren gemäß Anspruch 1, wobei das eine oder die mehreren amphoteren Tenside in Mengen von 50 g/l bis 500 g/l umfasst sind.

## Revendications

1. Une méthode comprenant :
a) la fourniture d'un substrat comprenant un ou plusieurs polymères et une pluralité de trous de liaison ;
b) l'application d'une composition de gonflement de solvant comprenant un ou plusieurs agents tensio-actifs amphotères choisis parmi des propionates n-alkylamino et des dipropionates n-alkylamino, un ou plusieurs solvants organiques et un ou plusieurs agents dispersants choisis parmi des agents tensio-actifs anioniques et des agents tensio-actifs non ioniques sur le substrat comprenant ces un ou plusieurs polymères et la pluralité de trous de liaison pour faire gonfler ces un ou plusieurs polymères ; et
c) l'application subséquente d'un agent d'oxydation sur ces un ou plusieurs polymères gonflés pour modifier ou décaper de façon topographique ces un ou plusieurs polymères dans la pluralité de trous de liaison.

2. La méthode de la revendication 1, comprenant en outre une étape consistant à métalliser des parois de la pluralité de trous de liaison.

3. La méthode de la revendication 1, dans laquelle ces un ou plusieurs solvants organiques sont choisis parmi des solvants organiques non miscibles dans l'eau et des solvants organiques miscibles dans l'eau.

4. La méthode de la revendication 3, dans laquelle le solvant organique non miscible dans l'eau est un éther phénylique glycol.

5. La méthode de la revendication 3, dans laquelle le solvant organique miscible dans l'eau est un éther de glycol.

6. La méthode de la revendication 1, dans laquelle le substrat est une carte de circuit imprimé.

7. La méthode de la revendication 1, dans laquelle ces un ou plusieurs agents tensio-actifs amphotères sont inclus dans des quantités de 50 g/L à 500 g/L.
